# DEMANDE DE BREVET EUROPEEN

(11) **EP 1 670 000 A1**
(43) Date de publication de la demande: **14.06.2006**
(21) Numéro de dépôt: 04292970.3
(22) Date de dépôt: 13.12.2004
(51) Int. Cl.: G11C 16/10, G06F 11/14, G06F 11/00, G11C 16/22

(54) **Procédé de sécurisation de l'écriture en mémoire contre des attaques par rayonnement ou autres.**

(71) Demandeur: Axalto S.A., 92120 Montrouge (FR)
(72) Inventeur: Giraud, Nicolas, c/o Axalto SA, 78431 Louveciennes Cedex (FR)
(74) Mandataire: Renault, Patricia Marie Jacqueline

(57) **Abrégé**

Le procédé selon la présente invention concerne un procédé de sécurisation de l'écriture dans des moyens de mémorisation d'un ensemble électronique comportant des moyens de traitement, ledit procédé comprenant un processus d'écriture atomique de données répertoriées dans un journal d'écritures. Le procédé consiste à contrôler une séquence d'écritures atomiques dans lesdits moyens de mémorisation en positionnant dans ledit journal des écritures un ou plusieurs indicateurs en mémoire comme témoin d'une ou des écritures successives répertoriées dans ledit journal.

La présente invention concerne également le module électronique dans lequel ledit procédé est implémenté et la carte comprenant ledit module.

## Description

La présente invention concerne un procédé et un dispositif de sécurisation d'un ensemble électronique mettant en oeuvre un programme à protéger. Plus précisément, le procédé vise à proposer une parade aux attaques par rayonnement, flash, lumière, laser, glitch, ou autres ou plus généralement à toute attaque perturbant l'exécution des instructions du programme. De telles attaques ont pour conséquence de modifier des instructions à exécuter et pour résultat l'inexécution ou la mauvaise exécution de certaines parties du programme.

### DOMAINE TECHNIQUE

Lors de l'exécution d'un programme par un microprocesseur, les attaques par exemple par injection de faute au moyen notamment de laser, glitch ou rayonnement électromagnétique ont pour conséquence de modifier les codes d'instructions exécutés par le processeur : les instructions du programme peuvent être remplacées par des instructions produisant un effet différent. De ce fait, un attaquant peut rendre inopérant un traitement sécuritaire dans un système d'exploitation pour carte à puce. Appliquée pendant une séquence d'instructions ayant pour but d'effectuer une écriture en mémoire non volatile de la carte, ces attaques peuvent permettre d'inhiber des écritures sécuritaires servant par exemple à comptabiliser un nombre d'authentifications incorrectes. Par ce type d'attaque, l'attaquant empêche également la mémorisation par la carte d'évènements significatifs du point de vue de la sécurité.

Parmi les parades connues, une solution consiste à positionner des drapeaux dans un octet de la mémoire RAM (Random Access Memory - Mémoire vive) à intervalles réguliers et à vérifier qu'à un point précis du déroulement du logiciel tous les drapeaux devant être positionnés le sont effectivement. Toutefois la mise en place de cette parade est fastidieuse car il est nécessaire d'allouer des zones de mémoire volatile spécifiques et de rajouter les traitements dans le code à protéger partout où cela est nécessaire. De plus, les attaques de ce type devenant de plus en plus courte et précises, les solutions connues perdent en efficacité. D'une part, l'attaque peut être suffisamment courte pour que le positionnement des drapeaux n'en soit pas affecté : les drapeaux en RAM peuvent indiquer au programme que toutes les écritures ont été effectuées correctement même si tel n'est pas le cas. D'autre part, le logiciel de vérification des drapeaux peut être lui-même perturbé.

Un but de la présente invention est de protéger l'ensemble des écritures contenues dans le programme.

Un autre but de la présente invention est de proposer une protection efficace même pour des attaques très courtes.

### RESUME DE L'INVENTION

La présente invention concerne un procédé de sécurisation de l'écriture dans des moyens de mémorisation d'un ensemble électronique comportant des moyens de traitement, ledit procédé comprenant un processus d'écriture atomique de données répertoriées dans un journal d'écritures, caractérisé en ce qu'il consiste à contrôler une séquence d'écritures atomiques dans lesdits moyens de mémorisation en positionnant dans ledit journal des écritures un ou plusieurs indicateurs en mémoire comme témoin d'une ou des écritures successives répertoriées dans ledit journal.

La présente invention concerne également un module électronique dans lequel ledit procédé est implémenté, une carte comprenant ledit module, un programme permettant d'implémenter ledit procédé.

### DESCRIPTION SOMMAIRE DES DESSINS

D'autres buts, avantages et caractéristiques de l'invention apparaîtront à la lecture de la description qui va suivre de la mise en oeuvre du procédé selon l'invention et d'un mode de réalisation d'un ensemble électronique adapté pour cette mise en oeuvre, donnés à titre d'exemple non limitatif en référence aux dessins ci-annexés dans lesquels :
- la figure 1 représente de manière schématique un exemple de dispositif dans lequel le procédé selon la présente invention est implémenté ;
- la figure 2 est une représentation schématique du contenu d'une partie de la mémoire d'un dispositif dans lequel le processus d'écriture atomique connu est implémenté ;
- la figure 3 est un graphe représentant les différentes étapes d'un processus d'écriture atomique connu ;
- la figure 4 est un graphe représentant les différentes étapes d'une forme de réalisation du procédé selon la présente invention ;
- la figure 5 est une représentation schématique du contenu d'une partie de la mémoire du dispositif selon une première forme de réalisation dans lequel le procédé selon la présente invention est implémenté ;
- la figure 6 est une représentation schématique du contenu d'une partie de la mémoire du dispositif selon une deuxième forme de réalisation dans lequel le procédé selon la présente invention est implémenté.

### MANIERE DE REALISER L'INVENTION

Le procédé selon l'invention vise à sécuriser un ensemble électronique, et par exemple un objet portable tel qu'une carte à puce mettant en oeuvre un programme. L'ensemble électronique comprend au moins des moyens de traitement tels qu'un processeur et des moyens de mémorisation tels qu'une mémoire. Le programme à sécuriser est installé dans la mémoire, par exemple de type ROM (Read Only Memory) dudit ensemble.

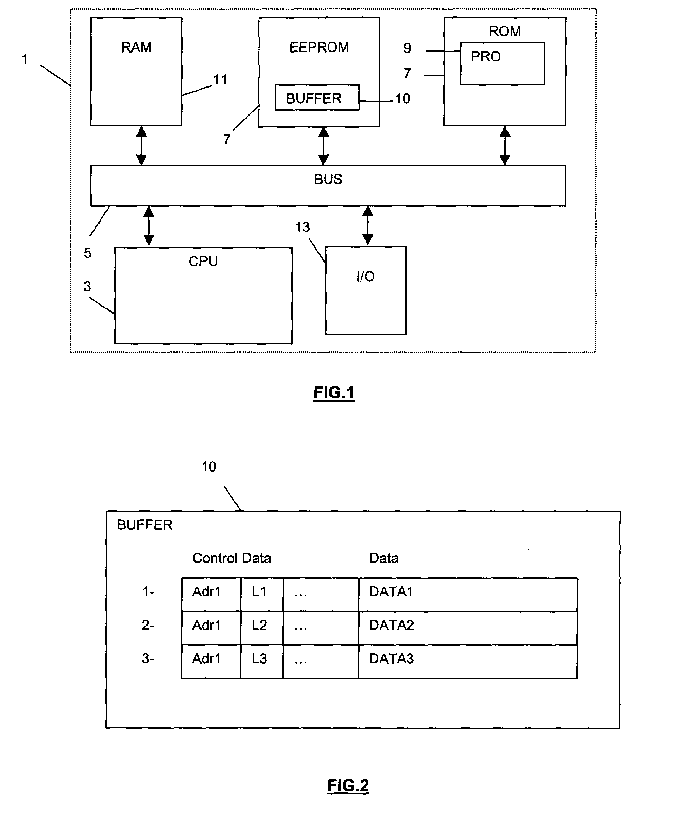

A titre d'exemple non limitatif, l'ensemble électronique décrit dans ce qui suit correspond à un système embarqué comprenant un module électronique 1 illustré sur la figure 1. De tels modules sont réalisés le plus souvent sous la forme d'un microcircuit électronique intégré monolithique, ou puce, qui une fois protégé physiquement par tout moyen connu peut être monté sur un objet portatif tel que par exemple une carte à puce, carte à microcircuit ou circuit intégré (carte à microprocesseur ...) ou autre utilisable dans divers domaines.

Le module électronique 1 comprend un microprocesseur CPU 3 relié de façon bidirectionnelle par un bus 5 interne à une mémoire 7 non volatile de type ROM, EEPROM (Electrical Erasable Programmable Read Only Memory), Flash, FeRam ou autre contenant le programme PRO 9 à exécuter et un buffer de transaction 10 contenant un journal d'écritures utilisé pour conserver temporairement des données, une mémoire 11 vive de type RAM, des moyens 13 I/O d'entrée/sortie pour communiquer avec l'extérieur.

Le procédé selon l'invention consiste à s'assurer que chaque écriture en mémoire non volatile lors de l'exécution du programme 9 est correctement effectuée.

Le procédé selon l'invention consiste à contrôler l'écriture atomique en mémoire non volatile de données en positionnant lors de l'exécution d'un programme 9 dans un journal d'écritures un indicateur en mémoire comme témoin d'une écriture. On entend par « journal d'écritures » la liste de toutes les opérations d'écriture à effectuer sur la mémoire de manière atomique, le journal contenant des données de contrôle et/ou des données à écrire et/ou tout autre type d'information. On entend par séquence d'écritures « atomiques » toutes les écritures inscrites dans le journal d'écritures telles que, si le journal est validé (fermeture de la séquence), toutes les écritures sont effectuées, même en présence d'une attaque ; si le journal n'est pas validé, aucune desdites écritures n'est réalisée. Selon la présente invention, l'écriture de l'indicateur en mémoire est rendue atomique avec l'écriture des données prévues dans le journal d'écritures.

Du fait du caractère atomique de chaque écriture dans le journal et de l'indicateur, la présence en mémoire de l'indicateur témoin garantit que l'écriture des données a effectivement été réalisée. La vérification de la présence de l'indicateur témoin permet au programme de s'assurer a posteriori que l'écriture a bien été effectuée. Dans le cas où l'écriture n'aurait pas été réalisée, des mesures diverses peuvent alors être prises comme par exemple le déclenchement par le programme 9 d'une parade sécuritaire, l'interruption de l'exécution du programme, le positionnement d'un indicateur de fraude en mémoire non volatile 7 avertissant d'une attaque frauduleuse et permettant par exemple d'interdire tout fonctionnement ultérieur du système d'exploitation.

Les méthodes pour effectuer plusieurs écritures dans la mémoire et plus particulièrement dans la mémoire 7 non volatile d'une carte à microprocesseur de manière atomique dans le but de pallier l'arrachement (« anti-tearing ») d'une carte sont connues. Elles utilisent par exemple, comme le montre la figure 2, le buffer 10 de transaction ; le buffer 10 de transaction se trouve en mémoire 7 non volatile et sert de journal des écritures à effectuer.

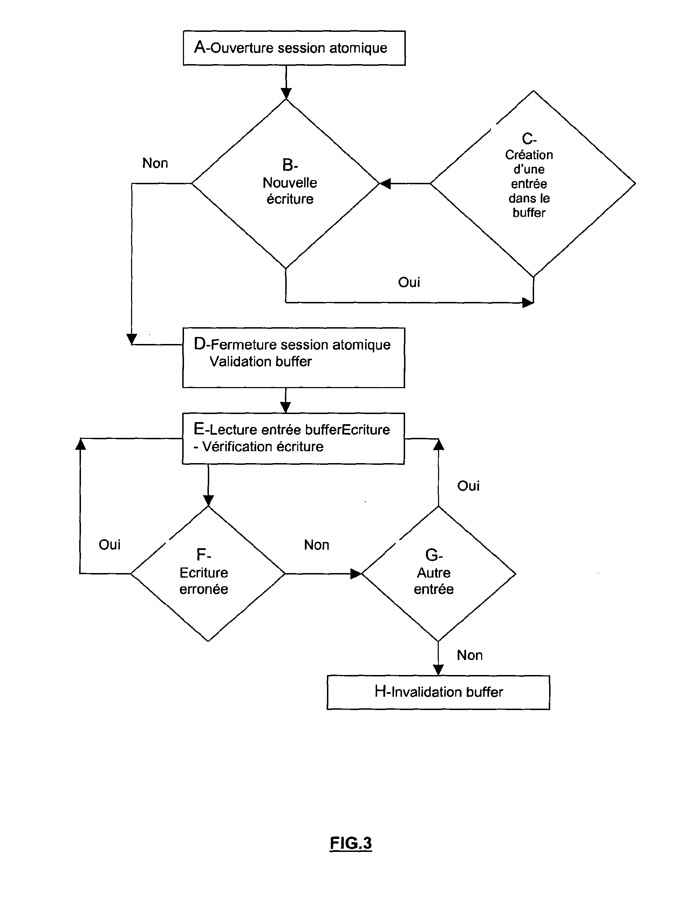

Le processus d'écriture atomique connu peut consister en la séquence suivante (se référer à la figure 3) :

Après l'ouverture de la session atomique (étape A), pour chaque écriture (étape B), le processus consiste à créer (étape C) une entrée dans le journal des écritures du buffer 10 de transaction comprenant les données de contrôle (Data Control) (adresse Adr1, Adr2, Adr3,..., longueur des données utiles, L1, L2, L3, ..., ...) et les données utiles (Data) (Data1, Data2, Data3, ...) (voir figure 2).

Lors de la fermeture de la session atomique (Etape D), le processus valide le buffer de transaction comme contenant une séquence d'écritures atomique.

Le procédé consiste alors à lire (étapes E, G) chaque entrée du journal et effectuer puis vérifier l'écriture correspondante en répétant toute écriture erronée (étape F). Puis, à l'étape H, le procédé invalide le buffer de transaction comme ne contenant aucune séquence d'écritures atomique.

En cas d'interruption des écritures de la séquence atomique, le processus reprend à l'étape E tant que le buffer de transaction n'a pas été invalidé.

Ce type de processus d'écriture atomique permet de se prémunir contre une interruption de la session atomique en cours : il garantit que
- soit les écritures inscrites dans le journal des écritures du buffer de transaction sont ignorées et aucune des écritures inscrites n'est effectuée si la session n'a pas été fermée ;
- soit toutes les écritures inscrites dans le journal du buffer de transaction sont effectuées si la session a été fermée.

Toutefois, ce type de processus ne permet pas de se prémunir contre des perturbations du fonctionnement du système permettant à la session de se poursuivre : une des écritures prévues dans la session atomique peut être empêchée sans que le mécanisme d'atomicité permette de le détecter.

Le procédé selon la présente invention consiste donc à combiner le processus connu d'écriture atomique des données avec l'écriture d'un indicateur d'écriture. L'indicateur est placé dans le journal des écritures. Les écritures des données et de l'indicateur sont rendues atomiques..

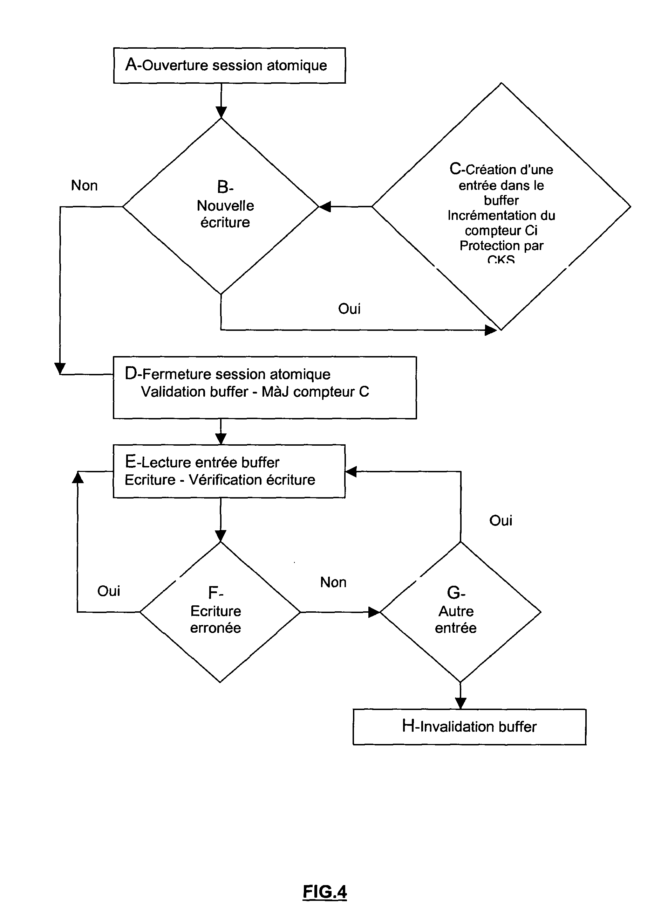

Le mode de réalisation décrit ci-après de la présente invention et illustré sur la figure 4 combine le processus d'atomicité comme celui décrit ci-dessus et un compteur jouant le rôle d'indicateur des écritures successives en mémoire non volatile au cours d'une commande, et par exemple un compteur du nombre d'écriture s'incrémentant à chaque nouvelle écriture.

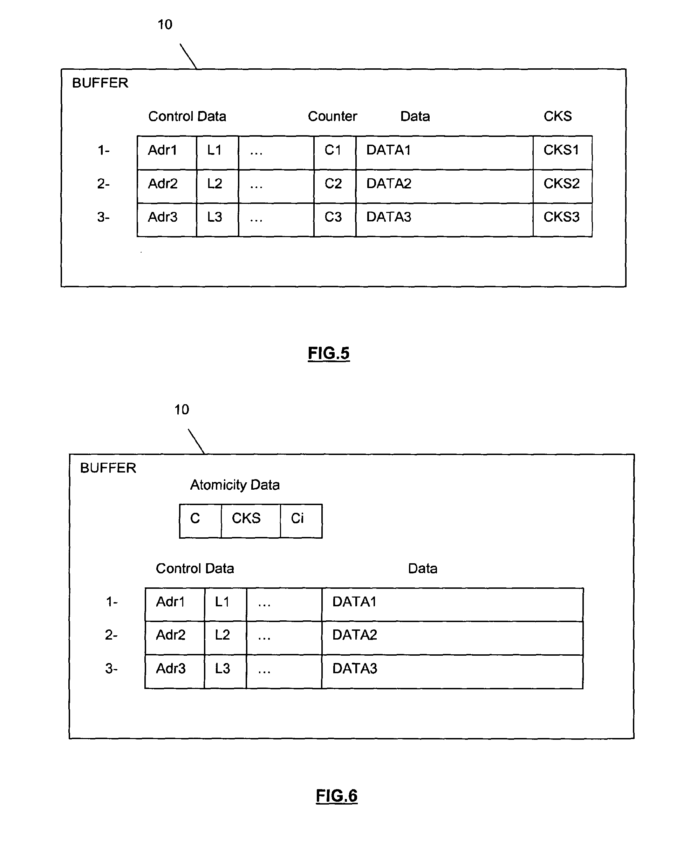

Comme le montre la figure 5, selon une forme de réalisation de l'invention, la valeur (Counter) du compteur d'écriture (C1, C2, C3) en EEPROM est inclus dans le bloc des données de contrôle du journal des écritures du processus d'atomicité (Control Data). Selon une autre forme de réalisation illustrée sur la figure 6, la valeur du compteur d'écriture est inclus dans les données d'atomicité du journal des écritures du processus d'atomicité (Atomicity Data). Pour chaque nouvelle écriture à l'intérieur de la session atomique, le compteur est incrémenté (étape C- figure 4) et les données de contrôle et d'atomicité sont mises à jour dans un même bloc sous la protection d'une somme de contrôle (CKS1, CKS2, CKS3 sur la figure 5 ou CKS sur la figure 6, suivant la forme de réalisation) sur une partie ou l'ensemble des données (étape C). Le compteur est incrémenté à chaque nouvelle écriture dans la session atomique. Le processus d'atomicité garantit qu'une fois la session atomique fermée, toutes les écritures enregistrées dans le journal seront effectuées complètement. Ce mode de réalisation garantit que chaque incrémentation du compteur est atomique avec l'écriture correspondante dans le journal. Lors de la fermeture de la session atomique en cours, chaque incrémentation du compteur durant la session atomique correspond à une écriture réellement effectuée lors de la fermeture de la session atomique.

Ainsi, comme le montre la figure 4, après l'ouverture de la session atomique, à chaque nouvelle écriture, soit à chaque nouvelle entrée dans le journal des écritures du buffer de transactions 10, le compteur est incrémenté (étape C). Suivant la forme de réalisation, la nouvelle valeur du compteur est écrite avec les données de contrôle de l'entrée concernée (C1, figure 5) ou encore dans les données d'atomicité (Ci, figure 6). La valeur du compteur avant ouverture de la session atomique est conservé dans les données d'atomicité (C, figure 6). Lors de la fermeture de la session atomique, la valeur du compteur est comparée à la valeur attendue et si tel est le cas, et si les autres vérifications prévues dans les processus d'écriture atomique connus sont également correctes, le buffer est validé. La valeur du compteur C avant ouverture de la session prend alors la valeur du compteur au moment de la fermeture.

Cette forme de réalisation utilisant un compteur permet de vérifier au cours de l'exécution du programme et/ou lors de la fermeture de la session atomique que les écritures prévues dans le journal ont été effectuées en comparant la valeur réelle du compteur avec la valeur attendue.

Le procédé selon l'invention consiste à incrémenter ledit compteur simultanément à chaque écriture atomique. Dans le cas où une attaque aurait eu lieu au cours de l'écriture, l'écriture n'a pas été effectuée correctement, le compteur n'est pas incrémenté et la valeur du compteur est différente de la valeur attendue ; l'attaque est ainsi détectée et une action spécifique est effectuée par le programme ou le processeur.

L'atomicité de l'enregistrement d'une nouvelle écriture dans le journal des écritures du buffer de transaction et de l'incrémentation du compteur d'écritures en mémoire non volatile est assurée par deux moyens :
- le placement du compteur dans le même bloc que tout ou partie des données de contrôle et/ou d'atomicité et/ou des données utiles du processus d'atomicité ; et/ou
- la protection du compteur et de tout ou partie des données de contrôle et/ou d'atomicité et/ou des données utiles par la même somme de contrôle qui valide cette écriture,
l'un des deux moyens seuls étant suffisant pour assurer l'atomicité. Les écritures dans la mémoire 7 non volatile de type EEPROM rencontrées habituellement dans les cartes à puce, s'effectuent par blocs (typiquement de 64 ou 128 octets). L'écriture de tous les octets programmés dans un même bloc est simultanée, donnant un caractère atomique à l'écriture de plusieurs octets dans le même bloc. La durée de programmation est la même pour un seul octet dans le bloc ou pour tous les octets dans le bloc, de l'ordre de 1 à 5 ms. Cette durée doit être multipliée par le nombre de blocs à écrire.

L'atomicité peut être réalisée en utilisant cette propriété intrinsèque de l'EEPROM. En plaçant l'indicateur témoin d'une écriture dans le même bloc que les données à écrire dans le journal des écritures, on peut s'assurer que la présence de l'indicateur témoin garantit l'écriture effective des données.

Le placement du compteur d'écritures dans le même bloc que les données de contrôle et/ou d'atomicité et/ou les données utiles du processus d'atomicité contribue à la performance du mécanisme de protection. Aucune écriture de bloc supplémentaire n'est nécessaire, ce qui évite un surcoût en écritures.

Le procédé selon l'invention consiste selon le deuxième moyen à effectuer le calcul d'une somme de contrôle (CKS1, CKS2, CKS3 sur la figure 5, CKS sur la figure 6) sur la valeur du compteur et sur tout ou partie des données de contrôle et/ou d'atomicité et/ou des données utiles simultanément à l'écriture dans le journal et à écrire la valeur obtenue pour la somme de contrôle dans le journal. Le procédé selon l'invention consiste ensuite à vérifier la somme de contrôle en la comparant à la valeur pré-calculée et inscrite en mémoire. Il est à noter que la somme de contrôle peut porter sur l'indicateur et tout ou partie des données utiles, et/ou une ou plusieurs données d'atomicité et/ou une ou plusieurs données de contrôle selon la forme de réalisation choisie. La protection du compteur d'écritures et des données de contrôle par une somme de contrôle sur l'ensemble garantit l'efficacité du mécanisme avec tout type de mémoire non volatile et par exemple avec d'autre type de mémoire que l'EEPROM.

## Revendications

1. Procédé de sécurisation de l'écriture dans des moyens (7) de mémorisation d'un ensemble électronique comportant des moyens de traitement, ledit procédé comprenant un processus d'écriture atomique de données répertoriées dans un journal d'écritures, **caractérisé en ce qu'**il consiste à contrôler une séquence d'écritures atomiques dans lesdits moyens de mémorisation en positionnant dans ledit journal d'écritures un ou plusieurs indicateurs en mémoire comme témoin d'une ou des écritures successives répertoriées dans ledit journal.

2. Procédé selon la revendication 1, **caractérisé en ce qu'**il consiste à assurer l'atomicité de l'écriture des données dans le journal avec celle de l'indicateur.

3. Procédé selon l'une des revendications 1 ou 2, **caractérisé en ce qu'**il consiste à protéger ledit indicateur et des données du journal d'écritures par la même somme de contrôle lors de l'écriture dudit indicateur et desdites données.

4. Procédé selon l'une des revendications 1 à 3, **caractérisé en ce que** l'atomicité des écritures est renforcée en utilisant une propriété de certaines mémoires selon laquelle les écritures sont effectuées par bloc, ledit indicateur étant placé dans le même bloc que des données à écrire du journal.

5. Procédé selon l'une des revendications 1 à 4, **caractérisé en ce qu'**il consiste à positionner ledit indicateur en incrémentant un compteur à chaque nouvelle écriture.

6. Procédé selon la revendication 5, **caractérisé en ce qu'**il consiste à placer la valeur dudit compteur dans le même bloc de données à écrire que des données de contrôle et/ou d'atomicité et/ou des données utiles du journal des écritures.

7. Procédé selon l'une des revendications 1 à 6, **caractérisé en ce qu'**il consiste à déclencher une action si l'écriture desdites données n'est pas réalisée.

8. Module électronique comportant des moyens de traitement et des moyens de mémorisation contenant un programme à exécuter et un journal des écritures répertoriant les écritures d'un processus d'écriture atomique **caractérisé en ce que** les moyens de traitement de l'information comportent des moyens permettant lors de l'exécution du programme, de positionner dans ledit journal des écritures un ou plusieurs indicateurs en mémoire comme témoin d'une ou des écritures successives répertoriées dans ledit journal.

9. Carte **caractérisée en ce qu'**elle comprend le module électronique selon la revendication 8.

10. Programme d'ordinateur comprenant des instructions de code de programme pour l'exécution des étapes du procédé selon l'une des revendications 1 à 7 lorsque ledit programme est exécuté dans un ensemble électronique.
